Europäisches Patentamt

**European Patent Office**

**Office européen des brevets**

(11) Veröffentlichungsnummer: **0 029 801**

**A1**

(12) **EUROPÄISCHE PATENTANMELDUNG**

(21) Anmeldenummer: **80730073.6**

(22) Anmeldetag: **14.11.80**

(51) Int. Cl.³: **H 02 H 3/04**
**H 03 F 1/52**

(30) Priorität: **27.11.79 DE 2948125**

(43) Veröffentlichungstag der Anmeldung:
**03.06.81 Patentblatt 81/22**

(84) Benannte Vertragsstaaten:
**AT BE CH DE FR GB IT LI LU NL**

(71) Anmelder: **Licentia Patent-Verwaltungs-GmbH**
**Theodor-Stern-Kai 1**
**D-6000 Frankfurt/Main 70(DE)**

(72) Erfinder: **Lotz, Alfred, Ing. grad.**
**Büchsenweg 14**
**D-1000 Berlin 51(DE)**

(72) Erfinder: **Dörks, Wolfgang, Ing. grad.**
**Blasewitzer-Ring 30**
**D-1000 Berlin 20(DE)**

(74) Vertreter: **Schickle, Gerhard, Dipl.-Ing.**
**Licentia Patent-Verwaltungs-GmbH Theodor-Stern-Kai 1**
**D-6000 Frankfurt/Main 70(DE)**

(54) **Schaltungsanordnung.**

(57) Es wird eine Schaltungsanordnung zur sicheren Überwachung der Ausgangssignale von Relais angegeben. Die Überwachungskontakte von Relais (a2, b2) sind in Reihe an die Eingänge einer Sperrschwingerschaltung (U, V4) mit Rückkopplungsübertrager gelegt. Die Sperrschwingerschaltung mit Rückkopplungsübertrager besteht aus einem Kondensator (C), einem Transistor (V4) mit Kollektorwiderstand, einem Spannungsteiler an der Basis des Transistors sowie weiteren Widerständen und Dioden. Sie ist mit den Primärwicklungen eines Kopplungsübertragers verbunden, an dessen Sekundärwicklung ein weiterer Transistor (V5) zur Verstärkung des dynamischen Ausgangssignals geschaltet ist. Mit Hilfe dieser Schaltungsanordnung wird die Ausgabe eines fehlerhaften Signals verhindert. Dadurch können Meldungen und Befehle mit Sicherheitsverantwortung aus fehlersicheren Schaltungen potentialfrei ausgegeben werden.

EP 0 029 801 A1

./...

Croydon Printing Company Ltd.

Fig. 2

Schaltungsanordnung

Die Erfindung betrifft eine Schaltungsanordnung nach dem Oberbegriff des Patentanspruches.

In sicherheitsempfindlichen technischen Prozessen muß im Fehlerfall die Ausgabe von Befehlen verhindert und eine sichere Fehlermeldung ausgegeben werden. Solche Überwachungen sind bereits bekannt wie z.B. in den Systemen LOGISTAT oder SIMATIC. Dabei ist jedoch noch von Nachteil, daß ein Fehler vorkommen kann, wenn die Überwachungsbausteine selbst defekt werden.

Die Aufgabe besteht daher darin, eine sichere Ausgabe fehlersicherer Meldungen über potentialfreie Kontakte zu ermöglichen. Die Aufgabe wird nach der Erfindung durch die im Patentanspruch angegebenen Maßnahmen gelöst.

Die Erfindung wird im folgenden anhand von Zeichnungen an einem Ausführungsbeispiel näher erläutert.

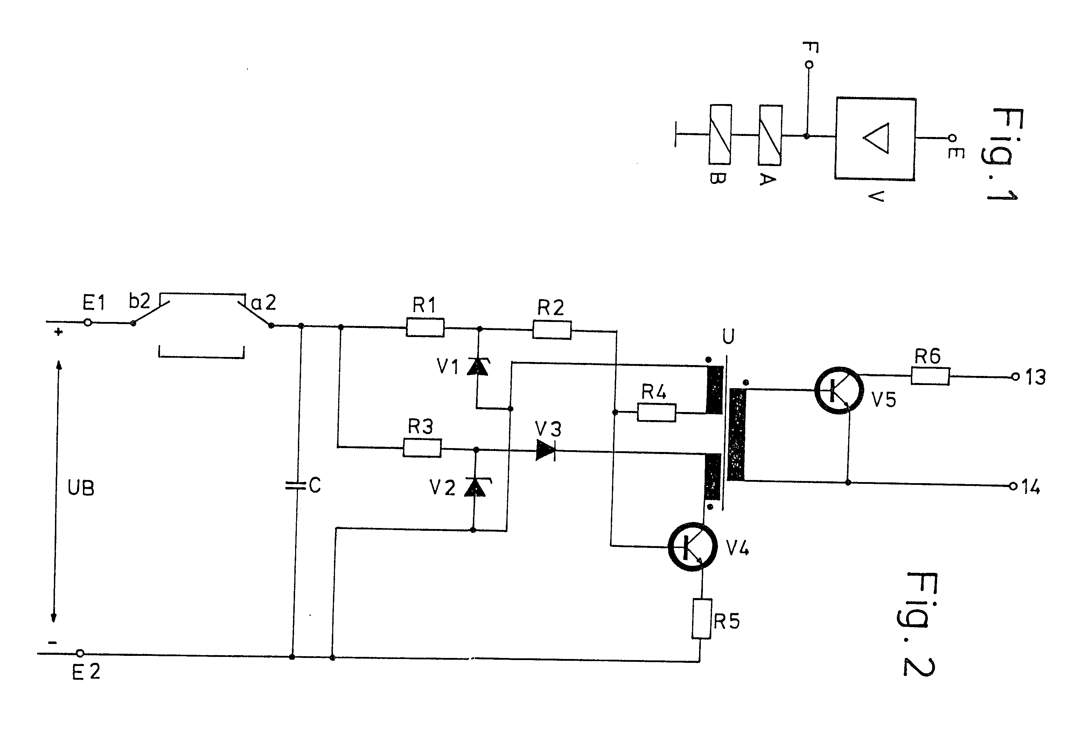

In Fig. 1 sind zwei zu überwachende Relais A, B dargestellt, denen über einen fehlersicheren Verstärker V Befehle zugeleitet werden. Die Befehle werden über den Eingang E eingegeben und über den Ausgang F ausgegeben. Die Relais A, B können sowohl in Reihe als auch parallel geschaltet sein. Jedes Relais hat Ausgabekontakte a1, b1 und überwachte Kontakte a2, b2. Durch den fehlersicheren Verstärker V ist bereits gewährleistet, daß richtige Signale zu den Relais A, B gelangen. Solche fehlersicheren Verstärker sind bereits in den Patentanmeldungen P 22 64 360 und P 25 44 426 vorgeschlagen worden.

Die Relais A und B sind voneinander unabhängig. Die Kontakte a2 und b2 dieser Relais sind exclusiv verbunden und werden auf störungsfreie Funktion überwacht.

In Fig. 2 ist die Schaltungsanordnung zur Überwachung der Kontakte a2, b2 dargestellt. An den Klemmen E1, E2 liegt die Betriebsspannung UB. Hinter der Klemme E1 liegen die überwachten Kontakte a2, b2. Ein Kondensator C überbrückt die Umschlagzeit der Kontakte a2, b2. Die Sperrschwingerschaltung besteht aus einem Transistor V4 mit seinem Kollektorwiderstand R5 sowie aus dem Spannungsteiler R2, R4, den Widerständen R1, R3 und den Dioden V1, V2, V3. Der Sperrschwinger ist verbunden mit den Primärwicklungen eines Rückkopplungsübertragers U. Die Primärwicklung des Übertragers U liegt im Basiskollektorkreis eines weiteren Transistors V5 mit seinem Emitterwiderstand R6. An der Klemme 13 wird ein dynamisches fehlersicheres Signal ausgegeben, das solange ansteht, solange keine Störung vorliegt. Klemme 14 liegt an Masse. In jedem denkbaren Fehlerfalle wird an der Klemme 13 ein Nullsignal und damit eine sichere Fehlermeldung ausgelöst.

Die Sperrschwingerschaltung erzeugt eine Impulsspannung, die durch den Übertrager U ausgekoppelt und in dem Transistor V5 verstärkt wird. Dabei werden mit Hilfe der Vorwiderstände R1 bzw. R3 und den Zehnerdioden V1 bzw. V2 die notwendigen Arbeitsspannungen für den Transistor V4 eingestellt. Der Spannungsteiler R2, R4 dient dabei zur Einstellung des Arbeitspunktes. Die Diode V3 schützt den Transistor V4 gegen Spannungsverpolung und über den Widerstand R5 wird durch Gegenstromkopplung eine Temperatur- und Frequenzstabilisierung des Transistors bewirkt.

Da die Relais A, B zwangsgeführte Kontakte besitzen, wird bei Unterbrechung oder bei Kleben der Relaiskontakte eine fehlersichere Fehlermeldung ausgegeben, die in einer nachgeschalteten, sicher arbeitenden Verknüpfungseinheit eine zusätzliche sichere Verriegelungsfunktion steuern kann. Am Ausgang F wird die Ausgabe eines fehlerhaften Signals verhindert.

Dadurch können Meldungen und Befehle mit Sicherheitsverantwortung aus fehlersicheren Schaltungen potentialfrei ausgegeben werden. Es wird dadurch ein wirtschaftlicher Aufbau mit geringer Störanfälligkeit und großer Flexibilität hinsichtlich der Anpassung an eine technische Systemkomponente ermöglicht.

- 1 -

Patentanspruch

Schaltungsanordnung zur sicheren Überwachung der Ausgangssignale von Relais, dadurch gekennzeichnet, daß die Überwachungskontakte der Relais in Reihe an den Eingängen einer
Sperrschwingerschaltung mit Rückkopplungsübertrager gelegt
sind, die aus einem Kondensator, einem Transistor mit
Kollektorwiderstand, einem Spannungsteiler an der Basis
des Transistors sowie weiteren Widerständen und Dioden besteht und mit den Primärwicklungen des Rückkopplungsübertragers verbunden ist, an dessen Sekundärwicklung ein weiterer Transistor zur Verstärkung des dynamischen Ausgangssignals geschaltet ist.

0029801

Fig.1

Fig.2

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | AT - B - 275 643 (SIEMENS GMBH)<br><br>* ganzes Dokument *<br><br>-- | Anspr. |
| A,D | DE - A1 - 2 544 426 (LICENTIA PATENT-<br>VERWALTUNGS-GMBH)<br><br>* Anspruch; Fig. *<br><br>-- | |
| A,D | DE - A - 2 264 360 (LICENTIA PATENT-<br>VERWALTUNGS-GMBH)<br><br>* Fig. *<br><br>---- | |

**KLASSIFIKATION DER ANMELDUNG (Int. Cl.³)**

H 02 H    3/04

H 03 F    1/52

**RECHERCHIERTE SACHGEBIETE (Int Cl.³)**

H 02 H    3/04

H 03 F    1/52

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| Berlin | 27-02-1981 | LEMMERICH |

EPA form 1503.1  06.78